# FASCICULE DE BREVET EUROPEEN

(11) **EP 4 626 186 B1**
(45) Date de publication et mention de la délivrance du brevet: **11.11.2026**
(21) Numéro de dépôt: 25163046.3
(22) Date de dépôt: 11.03.2025
(51) Int. Cl.: H10H 20/01, H10H 29/01

(54) **PROCÉDÉ DE FABRICATION DE DISPOSITIFS OPTO-ÉLECTRONIQUES**
VERFAHREN ZUR HERSTELLUNG OPTOELEKTRONISCHER VORRICHTUNGEN
METHOD OF MANUFACTURING OPTOELECTRONIC DEVICES

(30) Priorité: 19.03.2024 FR 2402720
(43) Date de publication de la demande: 01.10.2025
(73) Titulaire: Commissariat à l'Energie Atomique et aux Energies Alternatives, 75015 Paris (FR)
(72) Inventeur: SIMON, Julia, 38054 Grenoble Cedex 09 (FR); BALLOT, Clément, 38054 Grenoble Cedex 09 (FR); FOURNEL, Franck, 38054 Grenoble Cedex 09 (FR)
(74) Mandataire: Cabinet Beaumont

(56) Documents cités:
- EP-A1- 3 780 123
- EP-B1- 3 381 060
- FR-A1- 3 108 777

## Description

### Domaine technique

La présente description concerne de façon générale le domaine des dispositifs opto-électroniques. Elle vise plus particulièrement un procédé de fabrication de dispositifs opto-électroniques comportant chacun une pluralité de diodes semiconductrices, par exemple à base de nitrure de gallium (GaN) ou de nitrure d'indium-gallium (InGaN), et un circuit électronique de contrôle de ces diodes.

### Technique antérieure

Des dispositifs d'affichage émissifs comportant une matrice de diodes électroluminescentes (LED) à base de nitrure de gallium et un circuit électronique de contrôle, permettant de commander individuellement les LED pour afficher des images, ont déjà été proposés. L'utilisation de LED à base de nitrure de gallium a notamment permis de fabriquer des micro-écrans présentant des valeurs de luminance et des résolutions élevées.

Afin de réaliser de tels dispositifs, il peut être prévu de fabriquer le circuit de contrôle et la matrice de LED de façon séparée, puis de les connecter l'un à l'autre. La matrice de LED du dispositif peut en particulier être fabriquée par un procédé comprenant des étapes de formation d'un empilement actif de LED sur un substrat, de délimitation de zones émissives par photolithographie puis gravure de l'empilement actif de LED, et de réalisation de contacts d'anode et de cathode de chaque zone émissive et de lignes métalliques connectées à des plots permettant de relier les anodes et cathodes des zones émissives au circuit de contrôle. De tels procédés sont notamment décrits dans la demande internationale n° WO2017/068029 et dans le brevet français n° FR3079350 (DD18591/B16845), respectivement déposée et obtenu précédemment par le demandeur.

Une fois la matrice de LED réalisée, cette dernière est alors connectée au circuit de contrôle par une opération dite de câblage par fil (« wire bonding » en anglais), par l'utilisation de billes de soudure ou de piliers métalliques, ou par collage hybride du circuit de contrôle sur la matrice de LED, c'est-à-dire en empilant et en connectant ces deux éléments l'un à l'autre. Des exemples de collage hybride sont décrits dans la demande internationale n° WO2017/068029 et dans le brevet français n° FR3079350 susmentionnés.

Toutefois, un inconvénient de ce procédé réside dans la nécessité d'aligner précisément le circuit de contrôle et la matrice de LED lors de l'étape d'assemblage de ces deux éléments, de façon que chaque LED vienne correctement se positionner sur un plot métallique lui correspondant dans le circuit de contrôle. Cet alignement est notamment délicat à réaliser lorsque le pas des pixels diminue, et constitue un frein à l'augmentation de la résolution et/ou de la densité d'intégration des pixels.

Afin de pallier cet inconvénient, il a par ailleurs été proposé, notamment dans la demande internationale n° WO2017/194845 (DD16946/B15015) précédemment déposée par le demandeur, un procédé de fabrication de dispositifs opto-électroniques comprenant les étapes successives ci-dessous :
a) réaliser le circuit de contrôle sous la forme d'un circuit intégré comportant, sur une face, une pluralité de plots métalliques destinés à être connectés aux LED pour permettre un contrôle individuel du courant circulant dans chaque LED ;
b) reporter, sur la face du circuit de contrôle comportant les plots métalliques, un empilement actif de LED s'étendant de façon continue sur toute la surface du circuit de contrôle de sorte à connecter une couche semiconductrice de l'empilement actif de LED aux plots métalliques du circuit de contrôle ; et
c) structurer l'empilement actif de LED pour délimiter et isoler les unes des autres les différentes LED du dispositif.

Un avantage de ce procédé tient au fait que, lors de l'étape du report de l'empilement actif de LED sur le circuit de contrôle, les positions des différentes LED du dispositif dans l'empilement actif de LED ne sont pas encore définies. L'étape de report ne présente donc pas de contrainte forte en termes de précision d'alignement. La délimitation des différentes LED dans l'empilement actif peut ensuite être réalisée par des procédés de structuration d'un substrat et de dépôt de couches isolantes et conductrices sur un substrat, qui offrent une précision d'alignement nettement supérieure à celle qui peut être atteinte lors d'un report d'un substrat sur un autre.

Dans les procédés existants, l'empilement actif de LED est généralement formé, par croissance épitaxiale, sur une plaquette (« wafer », en anglais) en saphir. Bien que cela permette de réaliser des LED très performantes, l'utilisation de plaquettes en saphir présente en revanche l'inconvénient d'engendrer des coûts de fabrication élevés. Par ailleurs, les plaquettes en saphir présentent un diamètre égal à environ 100 ou 150 mm, tandis que les procédés mis en œuvre pour la réalisation des circuits de contrôle sont plutôt adaptés à des plaquettes en silicium présentant un diamètre supérieur, par exemple égal à environ 300 mm. Pour tenter de solutionner ces problèmes, des empilements actifs de LED à base de nitrure de gallium ont été réalisés sur des substrats en silicium, par exemple sur des plaquettes en silicium de diamètre sensiblement égal à celui des plaquettes servant à la réalisation des circuits de contrôle. Toutefois, les LED ainsi formées présentent, pour certaines longueurs d'onde d'émission notamment dans le vert et le rouge, des performances inférieures à celles obtenues en utilisant des plaquettes en saphir.

La demande de brevet européen n° EP 4016594 décrit une approche alternative consistant à reconstituer une plaquette de grand diamètre en reportant, sur une première plaquette en silicium présentant typiquement un diamètre égal à environ 200 ou 300 mm, des puces obtenues par découpe d'une deuxième plaquette en saphir de diamètre strictement inférieur à celui de la première plaquette et sur laquelle a préalablement été formé un empilement actif de LED. Toutefois, cette approche présente l'inconvénient de comporter une étape de découpe de la deuxième plaquette particulièrement complexe et coûteuse à réaliser, le saphir étant un matériau très dur et dont la découpe provoque la formation d'éclats en bord de puce. Par ailleurs, le procédé met en œuvre, postérieurement au report des puces sur la première plaquette, une étape de retrait des morceaux de la deuxième plaquette issus de l'étape précédente de découpe. Cette étape de retrait, effectuée par décollement au laser (« laser lift-off », en anglais), est délicate à maîtriser car la première plaquette comporte des circuits électroniques, par exemple de type CMOS (de l'anglais « Complementary Metal-Oxide-Semiconductor » - métal-oxyde-semiconducteur complémentaire), risquant d'être endommagés de manière irréversible par exposition à un faisceau laser.

Les couches à base de nitrure de gallium épitaxiées sur la deuxième plaquette sont en outre fortement contraintes, du fait de la différence de coefficient d'expansion thermique entre le saphir et le nitrure de gallium. Lors de la croissance épitaxiale, réalisée à haute température, la ou les couches à base de nitrure de gallium de l'empilement actif de LED sont épitaxiées sur une épaisse couche tampon en nitrure de gallium permettant une adaptation de paramètre de maille entre le saphir du substrat de croissance et le nitrure de gallium de l'empilement actif. Les contraintes sont ainsi progressivement relâchées à l'intérieur de la couche tampon, de sorte que les couches de l'empilement actif de LED ne soient pas, ou soient peu, contraintes à la température de croissance épitaxiale de ces couches. Lors du refroidissement de la deuxième plaquette, les contraintes exercées dans la couche tampon deviennent fortement compressives. Après que les morceaux de la deuxième plaquette, très rigide, ont été retirés, les contraintes de la couche de nitrure de gallium sont transmises à la première plaquette. Cela provoque des déformations très importantes de la première plaquette, par exemple de l'ordre de plusieurs centaines de micromètres, rendant par conséquent le traitement du substrat reconstitué incompatible avec des équipements de micro-électronique standards.

Le brevet européen n° EP 3780123 (DD19602/B18565), précédemment obtenu par le demandeur, décrit encore une autre approche consistant à effectuer deux reports pleine plaque avant découpe, permettant ainsi d'éviter de découper le saphir, suivis d'un report puce à plaque par collage non aligné du type de celui décrit dans la demande internationale n° WO2017/194845 susmentionnée. Les documents EP3381060B1 et FR3108777A1 décrivent aussi des procédés de fabrication de dispositifs opto-électroniques.

### Résumé de l'invention

Il existe un besoin de pallier tout ou partie des inconvénients des procédés de fabrication de dispositifs opto-électroniques existants.

Pour cela, un mode de réalisation prévoit un procédé de fabrication de dispositifs opto-électroniques, comprenant les étapes successives suivantes :
a) former, par croissance épitaxiale sur un substrat de croissance, un empilement actif de diode ;
b) reporter, sur un premier substrat de report, l'empilement actif de diode ;
c) retirer le substrat de croissance ;
d) former, par découpe du premier substrat de report et de l'empilement actif de diode, une pluralité de vignettes élémentaires ; et
e) reporter, sur un deuxième substrat de report, les vignettes élémentaires comprenant chacune une partie de l'empilement actif de diode.

Selon un mode de réalisation, le substrat de croissance ou le substrat de report, est chauffé, de préférence à une température supérieure ou égale à 40 °C, plus préférentiellement supérieure ou égale à 70 °C.

Selon un mode de réalisation, à l'étape b), le substrat de croissance et le substrat de report sont chauffés, de préférence à une température supérieure ou égale à 40 °C.

Selon un mode de réalisation, à l'étape b), l'empilement actif de diode est fixé sur le premier substrat de report par collage direct d'une première couche de collage, préalablement déposée sur la face de l'empilement actif de diode opposée au substrat de croissance, avec une deuxième couche de collage, préalablement déposée sur le premier substrat de report.

Selon un mode de réalisation, à l'étape b), les surfaces des première et deuxième couches de collage destinées à être mises en contact sont activées préalablement à la fixation.

Selon un mode de réalisation, les première et deuxième couches de collage sont en silicium amorphe.

Selon un mode de réalisation, les première et deuxième couches de collage sont des couches métalliques, de préférence en titane.

Selon un mode de réalisation, à l'étape e), les vignettes élémentaires sont fixées sur le deuxième substrat de report par collage direct d'une troisième couche de collage, préalablement déposée sur la face de l'empilement actif de diode opposée au premier substrat de report, avec une quatrième couche de collage, préalablement déposée sur le deuxième substrat de report.

Selon un mode de réalisation, les troisième et quatrième couches de collage sont en oxyde de silicium.

Selon un mode de réalisation, le procédé comprend en outre, après l'étape e), l'étape suivante :
f) reporter l'ensemble comprenant le deuxième substrat de report et les parties de l'empilement actif de diode sur un substrat actif comprenant des circuits intégrés de contrôle.

Selon un mode de réalisation, à l'étape f), les parties de l'empilement actif de diode et le deuxième substrat de report sont fixés au substrat actif par collage d'une première couche isolante, préalablement déposée sur la face de l'empilement actif de diode opposée au deuxième substrat de report, et de premiers éléments de reprise de contact, situés dans la première couche isolante, avec respectivement une deuxième couche isolante, préalablement déposée sur le substrat actif, et des deuxièmes éléments de reprise de contact, situés dans la deuxième couche isolante.

Selon un mode de réalisation, le procédé comprend en outre, après l'étape e), une étape g) de gravure des vignettes élémentaires de sorte à compenser un désalignement des vignettes élémentaires par rapport au deuxième substrat de report.

Selon un mode de réalisation, le procédé comprend en outre, après l'étape g), une étape h) de dépôt d'une couche isolante comblant des espaces s'étendant latéralement entre les vignettes élémentaires puis de retrait de parties de la couche isolante situées à l'aplomb des vignettes élémentaires.

Selon un mode de réalisation, le substrat de croissance est en saphir.

Selon un mode de réalisation, l'empilement actif de diode comprend du nitrure de gallium.

Selon un mode de réalisation, l'empilement actif de diode est un empilement de diode électroluminescente comportant, dans l'ordre à partir du substrat de croissance, des première et deuxième couches semiconductrices de types de conductivités opposés.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 1C, la figure 1D, la figure 1E, la figure 1F, la figure 1G, la figure 1H, la figure 1I, la figure 1J, la figure 1K, la figure 1L et la figure 1M sont des vues de côté et en coupe, schématiques et partielles, illustrant des structures obtenues à l'issue d'étapes d'un exemple d'un mode de réalisation d'un procédé de fabrication de dispositifs opto-électroniques ;
la figure 2A, la figure 2B, la figure 2C et la figure 2D sont des vues de côté et en coupe, schématiques et partielles, illustrant des structures obtenues à l'issue d'étapes d'une variante de mise en œuvre du procédé des figures 1A à 1M ; et
la figure 3A, la figure 3B, la figure 3C et la figure 3D sont respectivement une vue de dessus et des vues de côté et en coupe, schématiques et partielles, illustrant des structures obtenues à l'issue d'étapes d'une autre variante de mise en œuvre du procédé des figures 1A à 1M.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications susceptibles de tirer profit des dispositifs opto-électroniques décrits n'ont pas été détaillées, les modes de réalisation décrits étant compatibles avec toutes ou la plupart des applications mettant en œuvre au moins un dispositif opto-électronique, moyennant éventuellement des adaptations à la portée de la personne du métier à la lecture de la présente description. Par ailleurs, la réalisation d'un circuit intégré de contrôle de diodes semiconductrices n'a pas été détaillée, les modes de réalisation décrits étant compatibles avec les structures et procédés de fabrication usuels de tels circuits de contrôle. De plus, la composition et l'agencement des différentes couches d'un empilement actif de diode semiconductrice n'ont pas été détaillés, les modes de réalisation décrits étant compatibles avec les empilements actifs usuels de diodes semiconductrices, notamment à base de nitrure de gallium.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % près, de préférence à 5 % près.

Dans la description qui suit, les qualificatifs « isolant » et « conducteur » signifient respectivement, sauf précision contraire, électriquement isolant et électriquement conducteur.

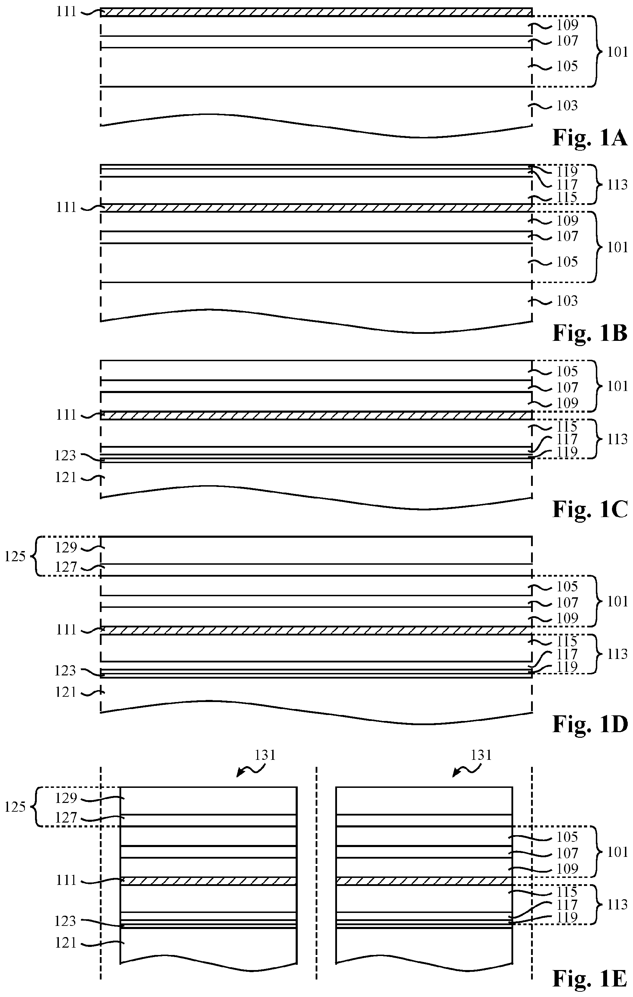

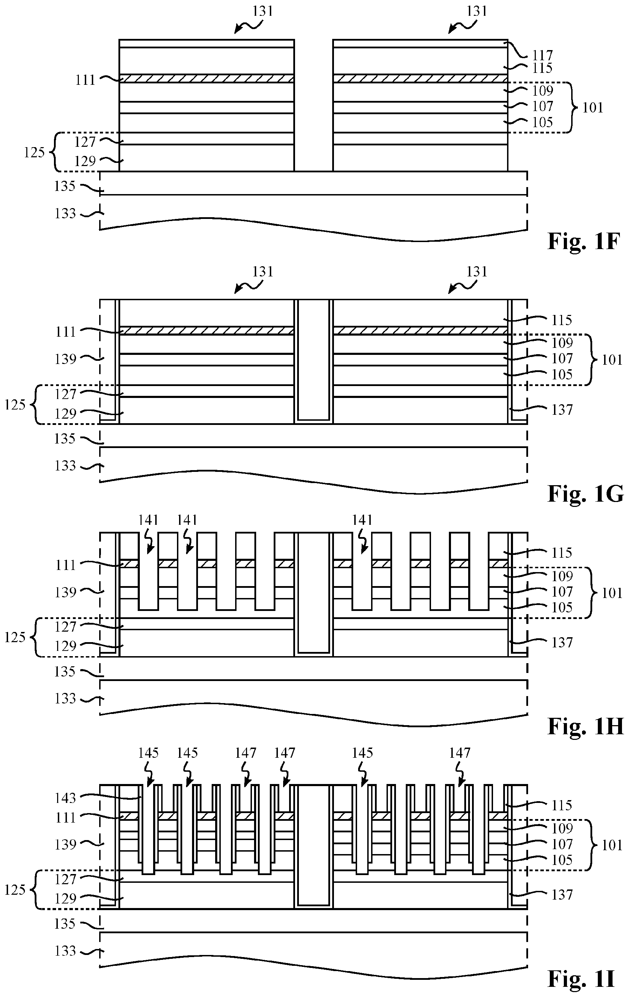

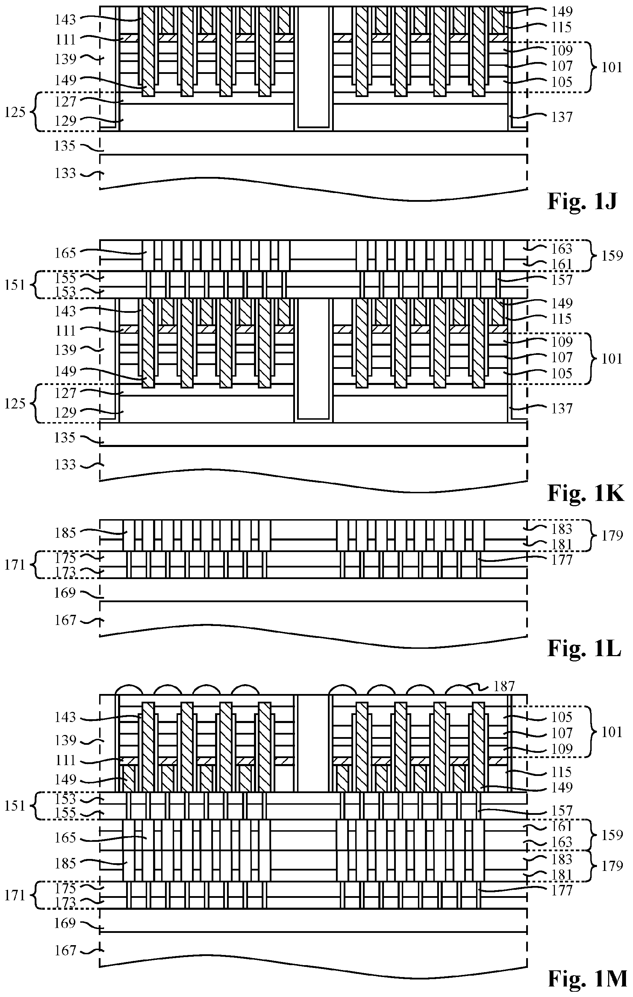

La figure 1A, la figure 1B, la figure 1C, la figure 1D, la figure 1E, la figure 1F, la figure 1G, la figure 1H, la figure 1I, la figure 1J, la figure 1K, la figure 1L et la figure 1M sont des vues de côté et en coupe, schématiques et partielles, illustrant des structures obtenues à l'issue d'étapes d'un exemple d'un mode de réalisation d'un procédé de fabrication de dispositifs opto-électroniques.

Les figures 1A à 1M illustrent plus particulièrement la fabrication d'un dispositif opto-électronique d'affichage comprenant une matrice de LED et un circuit électronique de contrôle permettant de commander individuellement les LED pour afficher des images.

La figure 1A illustre une structure obtenue à l'issue d'étapes de formation d'un empilement actif de LED 101 sur la face supérieure, dans l'orientation de la figure 1A, d'un substrat de croissance 103. L'empilement actif de LED 101 est par exemple à base de nitrure de gallium (GaN).

L'empilement actif de LED 101 est formé par croissance épitaxiale depuis la face supérieure du substrat de croissance 103. Le substrat de croissance 103 est par exemple une plaquette ou un morceau de plaquette. De préférence, le substrat de croissance 103 est en saphir. Le saphir présente en effet l'avantage de permettre la croissance d'un empilement de LED au nitrure de gallium de très bonne qualité.

Dans l'exemple représenté, l'empilement actif de LED 101 comprend, dans l'ordre à partir de la face supérieure du substrat de croissance 103, une couche en nitrure de gallium dopé de type N 105, une couche émissive 107, et une couche en nitrure de gallium dopé de type P 109. La couche émissive 107, ou couche active, comprend par exemple un empilement de plusieurs couches émissives formant des puits quantiques, par exemple des couches à base de nitrure de gallium, de nitrure d'indium (InN), de nitrure d'indium-gallium (InGaN), de nitrure d'aluminium-gallium (AlGaN), de nitrure d'aluminium (AlN), de nitrure d'aluminium-indium-gallium (AlInGaN), de phosphure de gallium (GaP), de phosphure d'aluminium-gallium (AlGaP), de phosphure d'aluminium-indium-gallium (AlInGaP), ou d'une combinaison quelconque d'un ou plusieurs de ces matériaux.

À titre de variante, la couche émissive 107 peut être une couche en nitrure de gallium intrinsèque, c'est-à-dire non intentionnellement dopée, par exemple présentant une concentration en espèces donneuses résiduelles comprise entre 10¹⁵ et 10¹⁸ at/cm³, par exemple de l'ordre de 10¹⁷ at/cm³.

Dans l'exemple illustré, la face inférieure de la couche émissive 107 est en contact avec la face supérieure de la couche 105, et la face supérieure de la couche émissive 107 est en contact avec la face inférieure de la couche 109. En pratique, un empilement d'une ou plusieurs couches tampon (non représentées), par exemple une couche de nitrure de gallium non dopée, peut former interface entre le substrat de croissance 103 et la couche en nitrure de gallium 105.

À titre d'exemple, l'épaisseur de la couche 105 est comprise entre 0,2 et 2 µm, par exemple de l'ordre de 1 µm. À titre d'exemple, l'épaisseur de la couche 107 est comprise entre 30 et 300 nm, par exemple de l'ordre de 100 nm. À titre d'exemple, l'épaisseur de la couche 109 est comprise entre 5 et 300 nm, par exemple de l'ordre de 100 nm. L'empilement actif de LED 101 s'étend par exemple de façon continue et sur une épaisseur uniforme sur toute la face supérieure du substrat de croissance 103.

La structure de la figure 1A comprend en outre, sur la face supérieure de l'empilement actif de LED 101, une couche métallique 111. Dans l'exemple représenté, la couche métallique 111 est déposée sur et en contact avec la face supérieure de la couche en nitrure de gallium 109. La couche métallique 111 est par exemple déposée par la mise en œuvre d'une technique de dépôt sous vide, par exemple par dépôt physique en phase vapeur (« Physical Vapor Deposition » - PVD, en anglais), par pulvérisation sous vide, par dépôt chimique en phase vapeur (« Chemical Vapor Deposition » - CVD, en anglais), ou par dépôt par évaporation sous vide. La couche métallique 111 assure notamment une fonction de reprise de contact électrique sur la couche semiconductrice 109 de l'empilement de LED 101. La couche métallique 111 peut en outre assurer une fonction de réflecteur optique, ou miroir, et/ou une fonction de barrière à la diffusion d'éléments métalliques.

À titre d'exemple, la couche métallique 111 est constituée d'un empilement de plusieurs couches métalliques distinctes (non détaillées sur les figures) comprenant, dans l'ordre à partir de la face supérieure de la couche semiconductrice 109 :
- une première couche métallique, par exemple en un oxyde transparent et conducteur tel que l'oxyde d'indium-étain (« Indium-Tin Oxide » - ITO, en anglais), en contact avec la face supérieure de la couche semiconductrice 109 et assurant la reprise d'un contact électrique sur la couche semiconductrice 109 ;
- une deuxième couche métallique, par exemple en nitrure de titane (TiN), en contact avec la face supérieure de la première couche métallique, la deuxième couche métallique formant une barrière à la diffusion d'éléments métalliques ; et
- une troisième couche métallique, par exemple en aluminium, en contact avec la face supérieure de la deuxième couche métallique, la troisième couche métallique possédant une fonction de réflecteur optique.

L'épaisseur de la première couche métallique est par exemple ajustée de sorte que la distance entre le puits quantique de la couche émissive 107 le plus proche de la couche 109 et la face supérieure de la deuxième couche métallique permette d'obtenir des interférences constructives de la lumière dans la structure. Cela permet ainsi une extraction de lumière optimale.

À titre d'exemple, la première couche métallique présente une épaisseur comprise entre 20 et 100 nm, par exemple égale à environ 60 nm. À titre d'exemple, la deuxième couche métallique présente une épaisseur comprise entre 1 et 10 nm, par exemple égale à environ 5 nm. À titre d'exemple, la troisième couche métallique présente une épaisseur comprise entre 100 et 200 nm, par exemple égale à environ 100 nm.

À titre de variante, la couche métallique 111 peut être constituée d'un empilement quelconque de couches en un oxyde transparent et conducteur, par exemple l'ITO, et/ou de couches à base d'un métal, d'un alliage métallique ou d'un oxyde métallique, par exemple à base de nickel, d'oxyde de nickel, d'aluminure de nickel, d'aluminium, d'argent, de platine, etc.

La figure 1B illustre une structure obtenue à l'issue d'une étape ultérieure de formation d'un empilement de collage 113 sur la face supérieure de la couche métallique 111 de la structure de la figure 1A.

L'empilement de collage 113 est par exemple choisi pour permettre un collage à chaud en utilisant un procédé de liaison par activation de surface (« Surface Activated Bonding » - SAB, en anglais) ou une technique de collage par diffusion atomique (« Atomic Diffusion Bonding » - ADB, en anglais), et un retrait ultérieur du matériau utilisé pour le collage sans endommager la couche semiconductrice 109. À titre d'exemple, le retrait ultérieur du matériau utilisé pour le collage peut être effectué par des procédés de gravure humide, par exemple par exposition à de l'acide fluorhydrique et/ou à de l'acide nitrique, ou par gravure sèche, par exemple par gravure ionique réactive profonde (« Deep Reactive Ion Etching » - DRIE, en anglais) en utilisant par exemple de l'hexafluorure de soufre (SF₆).

À titre d'exemple, l'empilement de collage 113 comprend, dans l'ordre à partir de la face supérieure de la couche métallique 111, une couche isolante 115, une couche optionnelle en nitrure de silicium (SiN) 117, et une couche de collage 119. Dans l'exemple illustré, la face inférieure de la couche 117 est en contact avec la face supérieure de la couche 115, et la face supérieure de la couche 117 est en contact avec la face inférieure de la couche 119. La couche 115 comprend par exemple au moins une couche en un oxyde, en un nitrure ou en un oxynitrure. À titre d'exemple, la couche 115 est en oxyde de silicium (SiO₂), en nitrure de silicium ou en oxynitrure de silicium (SiON). À titre de variante, la couche 115 peut être une couche d'arrêt de gravure constituée par exemple d'une couche en titane, présentant par exemple une épaisseur de l'ordre de 10 nm, revêtue d'une couche en nitrure de titane, présentant par exemple une épaisseur de l'ordre de 50 nm.

La couche de collage 119 est par exemple en silicium amorphe (a-Si).

À titre d'exemple, la couche 115 présente une épaisseur comprise entre 300 et 600 nm. À titre d'exemple, la couche 117 présente une épaisseur de l'ordre de 200 nm. À titre d'exemple, la couche 119 présente une épaisseur de l'ordre de 20 nm.

La figure 1C illustre une structure obtenue à l'issue d'étapes ultérieures de report et de fixation de l'empilement actif de LED 101 sur la face supérieure d'un substrat de report temporaire 121, ou poignée, puis de retrait du substrat de croissance 103.

Au préalable, une couche de collage 123 est par exemple formée sur la face supérieure, dans l'orientation de la figure 1C, du substrat de report temporaire 121. Le substrat 121 est par exemple une plaquette ou un morceau de plaquette en un matériau semiconducteur, par exemple le silicium. Le substrat 121 présente par exemple des dimensions latérales sensiblement égales à celles du substrat de croissance 103.

La couche de collage 123 est par exemple en le même matériau que la couche de collage 119, par exemple en silicium amorphe. La couche de collage 123 présente par exemple une épaisseur sensiblement identique à celle de la couche de collage 119, par exemple de l'ordre de 20 nm. La couche de collage 123 s'étend par exemple de façon continue sur toute la face supérieure du substrat 121. En fonction d'un état de surface recherché, la couche de collage 123 peut être soumise à une opération de planarisation préalablement à l'étape de report.

Au cours de l'étape de report, l'ensemble comportant le substrat de croissance 103, l'empilement actif de LED 101, la couche métallique 111 et l'empilement de collage 113 peut être retourné et rapporté sur le substrat de report temporaire 121 de façon à mettre la face supérieure (dans l'orientation de la figure 1B) de la couche de collage 119 en contact avec la face supérieure de la couche de collage 123. Dans cet exemple, la fixation de l'empilement actif de LED 101 sur le substrat de report temporaire 121 est obtenue par collage direct de la face inférieure (dans l'orientation de la figure 1C) de la couche de collage 119 sur la face supérieure de la couche de collage 123. L'expression « collage direct » signifie ici que le collage est un collage spontané sans présence de couche fluide, par exemple une couche de colle, en surface. Bien qu'il s'agisse d'un collage spontané, une pression peut être appliquée au moment du collage.

À titre d'exemple, le collage est plus précisément un collage covalent sous ultra-vide avec contrôle de température des substrats 103 et 121. Les surfaces destinées à être mises en contact sont par exemple préalablement activées, par exemple par un bombardement d'atomes d'argon présentant une énergie de l'ordre de 200 eV jusqu'à atteindre une dose de l'ordre de 10¹⁵ at/cm². Cette activation est par exemple réalisée par la mise en œuvre de la technique SAB précédemment évoquée. À titre de variante, le collage par activation de surface (SAB) peut être remplacé par un collage par diffusion atomique (« Atomic Diffusion Bonding » - ADB, en anglais) avec un dépôt sous ultravide de silicium amorphe de faible épaisseur, par exemple comprise entre 1 et 10 nm. Cette couche peut avantageusement remplacer la couche préalablement déposée sur les surfaces.

Préalablement à la mise en contact des deux surfaces de collage, au moins l'un des substrats - parmi le substrat de croissance 103 et le substrat de report temporaire 121 - est par exemple chauffé. À titre d'exemple, l'un des substrats 103, 121 est chauffé à une température environ 20 °C ou environ 50 °C plus élevée que la température ambiante, par exemple une température supérieure ou égale à 40 °C ou supérieure ou égale à 70 °C. Dans un cas où le substrat de croissance 103 présente un coefficient d'expansion thermique strictement supérieur à celui de la couche 105 et où la couche 105 présente un coefficient de dilatation thermique strictement supérieur à celui du substrat de report temporaire 121, les substrats 103 et 121 sont avantageusement chauffés à des températures différentes, la température de chauffage du substrat 103 étant par exemple strictement supérieure à celle du substrat 121. Le fait de chauffer le substrat de croissance 103 permet de relaxer les contraintes dans la couche 105 car cela permet de se rapprocher de la température de croissance. Une fois le collage effectué et la structure refroidie à température ambiante, la différence de coefficient d'expansion thermique entre les matériaux du substrat 121 et du substrat 103 provoque une augmentation de la contrainte dans les substrats 103 et 121. À l'issue de l'étape de retrait du substrat de croissance 103, la couche 105 sera moins contrainte, donc entraînera moins de déformations du substrat de report 121 du fait de la différence de coefficients d'expansion thermique entre la couche 105 et le substrat de report temporaire 121. Le choix des températures auxquelles sont portés les substrats 103 et 121 avant collage est par exemple conditionné par la recherche d'un compromis entre deux objectifs :
- maintenir l'intégrité de la structure lors du retour à la température ambiante, car si des contraintes trop importantes sont imposées entre le substrat 121 et le substrat 103 il est possible d'atteindre la limite de rupture des matériaux ; et
- obtenir un faible gauchissement (« bow », en anglais) du substrat de report 121 après retrait du substrat de croissance 103, par exemple inférieur à 100 ou 120 µm de sorte à permettre le traitement de la structure par des équipements de microélectronique standards, notamment des équipements de gravure sèche de type RIE (« Reactive Ion Etching » - gravure ionique réactive, en anglais) ou ICP (« Inductively Coupled Plasma » - plasma à couplage inductif, en anglais).

À titre d'exemple, dans le cas où le substrat 103 présente un coefficient d'expansion thermique strictement supérieur à celui de la couche 105 et où la couche 105 présente un coefficient de dilatation thermique strictement supérieur à celui du substrat 121, le substrat de croissance 103 est chauffé à une température comprise entre 95 et 150 °C, et le substrat de report 121 est chauffé à une température de l'ordre de 40 °C. À titre de variante, le substrat de report 121 peut ne pas être chauffé et être par exemple maintenu à température ambiante, par exemple à environ 20 °C. En fonction des matériaux dont sont constitués les substrats 103 et 121, le substrat de report 121 peut, à titre de variante, être chauffé à une température supérieure à celle du substrat de croissance 103, le substrat de croissance pouvant dans ce cas être chauffé ou non. Cela correspond par exemple à un cas dans lequel le substrat 103 présente un coefficient d'expansion thermique strictement inférieur à celui du substrat 121.

À titre de variante, le substrat de croissance 103 et le substrat de report temporaire 121 sont chauffés, par exemple à une température environ 20 ou 25 °C plus élevée que la température ambiante. À titre d'exemple, les substrats 103 et 121 sont chauffés chacun à une température supérieure ou égale à 40 ou à 45 °C.

Le retrait du substrat de croissance 103 est par exemple effectué par la mise en œuvre d'une technique de décollement au laser (« Laser Lift-Off » - LLO, en anglais) durant laquelle un faisceau laser est projeté à travers le substrat 103 depuis sa face opposée à l'empilement actif de LED 101. Dans le cas où le substrat de report temporaire 121 présente un gauchissement à l'issue du report et de la fixation de l'empilement actif de LED 101, le faisceau laser est par exemple commandé de sorte à effectuer un balayage en spirale plutôt qu'un balayage ligne par ligne. L'étape de décollement au laser est par exemple suivie d'une étape de retrait de billes de gallium formées sur la face supérieure de la couche 105 sous l'action du laser, par exemple par traitement humide à l'acide chlorhydrique ou à l'eau chaude.

Dans l'exemple représenté, la couche 105 a été amincie, par exemple par RIE ou ICP du côté de sa face supérieure, dans l'orientation de la figure 1C.

La figure 1D illustre une structure obtenue à l'issue d'étapes ultérieures de formation d'un autre empilement de collage 125 sur la face supérieure de la couche semiconductrice 105 de la structure de la figure 1C.

À titre d'exemple, l'empilement de collage 125 comprend, dans l'ordre à partir de la face supérieure de la couche semiconductrice 105, une couche d'arrêt de gravure 127, par exemple en nitrure de silicium, et une couche de collage 129, par exemple en oxyde de silicium. Dans l'exemple représenté, la face inférieure de la couche 127 est en contact avec la face supérieure de la couche 105, et la face supérieure de la couche 127 est en contact avec la face inférieure de la couche 129. À titre d'exemple, la couche d'arrêt de gravure 127 présente une épaisseur égale à environ 150 nm. À titre d'exemple, la couche de collage 129 présente une épaisseur de l'ordre de 600 nm.

Par ailleurs, au cours de cette étape, la face supérieure de la couche de collage 129 est par exemple planarisée, par exemple par CMP (de l'anglais « Chemical and Mechanical Polishing » - polissage mécano-chimique).

La figure 1E illustre une structure obtenue à l'issue d'une étape ultérieure de découpe de la structure de la figure 1D en une pluralité de vignettes élémentaires 131. Plus précisément, l'ensemble comprenant le substrat de report temporaire 121, la couche de collage 123, l'empilement de collage 113, la couche métallique 111, l'empilement actif de LED 101 et l'empilement de collage 125 est découpé en une pluralité de vignettes élémentaires 131.

Dans l'exemple représenté, chaque vignette 131 comprend des parties du substrat de report temporaire 121, de la couche de collage 123, de l'empilement de collage 113, de la couche métallique 111, de l'empilement actif de LED 101 et de l'empilement de collage 125. À titre d'exemple, la découpe des vignettes 131 est effectuée par sciage. Les vignettes 131 présentent par exemple des dimensions identiques.

De façon avantageuse, une étape préalable d'inspection de la structure de la figure 1D peut être prévue de façon à détecter des défauts épitaxiaux. La découpe peut ensuite être mise en œuvre de sorte à concentrer les défauts pour faire en sorte de sélectionner ultérieurement les vignettes 131 qui présentent de faibles taux de défauts.

La figure 1F illustre une structure obtenue à l'issue d'étapes ultérieures de report et de fixation des vignettes 131 sur la face supérieure d'un substrat de report temporaire 133, ou poignée, puis de retrait du substrat de report temporaire 121 et des couches de collage 119 et 123.

Au préalable, une couche de collage 135 est par exemple formée sur la face supérieure, dans l'orientation de la figure 1F, du substrat de report temporaire 133. Le substrat 133 est par exemple une plaquette ou un morceau de plaquette en un matériau semiconducteur, par exemple le silicium. Le substrat 133 présente par exemple des dimensions latérales strictement supérieures à celles du substrat de croissance 103.

La couche de collage 135 est par exemple en le même matériau que la couche de collage 129, par exemple en oxyde de silicium. La couche de collage 135 présente par exemple une épaisseur sensiblement identique ou inférieure à celle de la couche de collage 129, par exemple de l'ordre de 200 nm. La couche de collage 135 s'étend par exemple de façon continue sur toute la face supérieure du substrat 133.

Au cours de l'étape de report, les vignettes 131 peuvent être retournées et rapportées sur le substrat temporaire 133 de façon à mettre la face inférieure (dans l'orientation de la figure 1F) de la couche de collage 129 en contact avec la face supérieure de la couche de collage 135. Dans cet exemple, la fixation de l'empilement actif de LED 101 sur le substrat de report temporaire 133 est obtenue par collage direct de la face inférieure (dans l'orientation de la figure 1F) de la couche de collage 129 sur la face supérieure de la couche de collage 135. Le collage direct des vignettes 131 sur le substrat de report temporaire 133 est par exemple un collage moléculaire, un collage par thermocompression, ou encore un collage eutectique.

Les parties du substrat de report 121 et des couches de collage 119 et 123 comprises dans chaque vignette 131 sont par exemple ensuite retirées par meulage.

La figure 1G illustre une structure obtenue à l'issue d'étapes ultérieures de dépôt d'une couche d'encapsulation 137, de dépôt d'une couche isolante de passivation 139, et de planarisation de la structure.

Dans l'exemple représenté, la couche d'encapsulation 137 est déposée du côté de la face supérieure de la structure de la figure 1F. Dans cet exemple, la couche 137 revêt les faces latérales et les faces supérieures des vignettes 131. La couche 137 est alors, après dépôt, par exemple plus précisément située sur et en contact avec les faces supérieures des parties de la couche 117 (ou de la couche 115, dans le cas où la couche 117 est omise) et sur et en contact avec les faces latérales de l'empilement de collage 125, de l'empilement actif de LED 101, de la couche métallique 111, de la couche 115 et de la couche 117. La couche d'encapsulation 137 est par exemple destinée à protéger les faces latérales des vignettes 131 contre des infiltrations de liquides utilisés lors d'étapes ultérieures de gravure humide.

À titre d'exemple, la couche d'encapsulation est en nitrure de silicium.

Dans l'exemple illustré, la couche isolante de passivation 139 est ensuite déposée sur toute la face supérieure de la structure. La couche 139 est par exemple déposée sur une épaisseur supérieure à l'épaisseur cumulée de l'empilement de collage 125, de l'empilement actif de LED 101, de la couche métallique 111, de la couche 115 et de la couche 117. La couche 139 est par exemple en un oxyde, par exemple l'oxyde de silicium. À titre d'exemple, la couche 139 présente une épaisseur de l'ordre de quelques micromètres, par exemple égale à environ 3 ou 4 µm. La couche 139 est par exemple ensuite planarisée, par exemple par CMP, de façon à obtenir un assemblage présentant une face supérieure sensiblement plane. La planarisation est par exemple effectuée avec arrêt sur la couche 117. La couche 117 est par exemple ensuite retirée par gravure. À titre d'exemple, à l'issue de l'étape de planarisation, la face supérieure de la couche isolante 115 affleure la face supérieure de la couche isolante de passivation 139.

La figure 1H illustre une structure obtenue à l'issue d'une étape ultérieure de délimitation et d'individualisation d'une pluralité de LED élémentaires dans chaque vignette 131.

Dans l'exemple représenté, des tranchées 141 sont formées dans l'empilement de LED 101. Dans cet exemple, chaque tranchée s'étend verticalement, depuis la face supérieure de la couche isolante 115, à travers la couche conductrice 111, à travers les couches semiconductrices 109 et 107, et s'interrompt dans l'épaisseur de la couche 105. À titre d'exemple, les tranchées 141 sont réalisées par gravure en utilisant le matériau de la couche 115 comme masque dur.

La figure 1I illustre une structure obtenue à l'issue d'étapes ultérieures de dépôt d'une autre couche isolante de passivation 143 et de formation de tranchées 145 et de vias 147.

Dans l'exemple représenté, la couche isolante de passivation 143 est déposée sur toute la face supérieure de la structure. La couche 143 est par exemple déposée de manière conforme dans les tranchées 141, par exemple par un procédé de type ALD (de l'anglais « Atomic Layer Deposition » - dépôt de couches atomiques) ou PECVD (« Plasma-Enhanced Chemical Vapor Deposition » dépôt chimique en phase vapeur assisté par plasma). La couche 143 est par exemple en un oxyde, par exemple l'oxyde d'aluminium, en un nitrure, par exemple le nitrure de silicium ou le nitrure d'aluminium, ou en un empilement de couches en ces matériaux. La couche 143 est par exemple ensuite gravée de manière anisotrope de manière à découvrir le fond de la tranchée 141, par exemple par gravure sèche de type RIE ou ICP.

Dans l'exemple illustré, les tranchées 145 sont formées dans le prolongement des tranchées 141 précédemment réalisées. Les tranchées 145 présentent des dimensions latérales strictement inférieures à celles des tranchées 141, les parois latérales de chaque tranchée 145 étant constituées par des parties de la couche isolante de passivation 143. Dans l'exemple illustré, chaque tranchée 145 s'étend verticalement, depuis la face supérieure de la couche isolante 115, à travers la couche conductrice 111, à travers les couches semiconductrices 109, 107 et 105, et s'interrompt dans l'épaisseur de la couche 127 de l'empilement de collage 125. Les tranchées 145 permettent, entre autres, d'isoler la partie de la couche semiconductrice 105 de chaque LED élémentaire par rapport aux parties de la couche 105 des autres LED.

Dans l'exemple représenté, les vias 147 présentent une profondeur inférieure à celle des tranchées 145. Les vias 147 s'étendent verticalement, depuis la face supérieure de la couche 115, à travers toute l'épaisseur de la couche 115. Dans l'exemple illustré, le fond de chaque via 147 est constitué par une partie de la face supérieure de la couche conductrice 111.

La figure 1J illustre une structure obtenue à l'issue d'une étape ultérieure de formation de régions conductrices 149 à l'intérieur des tranchées 145 et des vias 147. Dans l'exemple représenté, les régions 149 comblent les tranchées 145 et les vias 147.

À titre d'exemple, les régions 149 sont réalisées par des dépôts successifs, du côté de la face supérieure de l'assemblage :
- d'au moins une couche miroir s'étendant sur et en contact avec les faces latérales et le fond des tranchées 145 et des vias 147 ;
- d'au moins une couche de germination s'étendant sur et en contact avec la couche miroir ; et
- d'au moins une couche de remplissage.

À titre d'exemple, la couche miroir est une couche en aluminium ou une couche en titane revêtue d'une couche en aluminium. À titre d'exemple, la couche de germination est constituée d'un empilement de plusieurs couches comprenant, dans l'ordre à partir de la couche miroir, une couche en titane, une couche en nitrure de titane et une couche en cuivre. À titre d'exemple, la couche de remplissage est en un métal, par exemple le cuivre, ou en un alliage métallique.

Les régions 149 sont par exemple réalisées par un procédé de type damascène. La couche miroir est par exemple formée par dépôt par faisceau ionique (« Ion Beam Deposition » - IBD, en anglais) ou par dépôt physique en phase vapeur. La couche de remplissage est par exemple formée par dépôt électrochimique.

La couche de remplissage est par exemple déposée sur toute la face supérieure de l'assemblage, sur une épaisseur suffisante pour combler les tranchées 145 et les vias 147. Une étape de planarisation de la face supérieure de l'assemblage, par exemple par polissage mécano-chimique, est par exemple ensuite mise en œuvre de sorte que les régions 149 affleurent les faces supérieures des parties de la couche 115.

La figure 1K illustre une structure obtenue à l'issue d'étapes ultérieures de formation d'un empilement 151 de couches isolantes 153 et 155 sur la face supérieure de la structure de la figure 1J, de réalisation de vias conducteurs traversants 157 dans l'empilement 151, de formation d'un empilement 159 de couches isolantes 161 et 163 sur l'empilement 151, et de formation d'éléments de reprise de contact 165 dans l'empilement 159.

À titre d'exemple, les couches isolantes 153 et 155 sont respectivement en nitrure de silicium et en oxyde de silicium. Les vias conducteurs 157 sont par exemple en un métal, par exemple le cuivre, ou en un alliage métallique. Les vias conducteurs 157 sont par exemple réalisés par la mise en œuvre d'un procédé de type damascène. Les vias conducteurs 157 permettent par exemple de réaliser un ajustement de la proportion de matériau conducteur sur la face supérieure de l'assemblage. Dans l'exemple représenté, chaque via conducteur 157 s'étend verticalement à travers tout l'empilement 151, et est situé sur et en contact avec la face supérieure de l'une des régions 149.

À titre d'exemple, les couches isolantes 161 et 163 sont respectivement en nitrure de silicium et en oxyde de silicium. Les éléments de reprise de contact 165 sont par exemple réalisés par la mise en œuvre d'un procédé de type damascène, par exemple du type décrit dans le brevet français n° FR3079350 (DD18591/B16845), obtenu précédemment par le demandeur. Les éléments de reprise de contact 165 sont par exemple en un métal, par exemple le cuivre, ou en un alliage métallique. Dans l'exemple représenté, chaque élément de reprise de contact 165 s'étend verticalement à travers tout l'empilement 159, et est situé sur et en contact avec la face supérieure de l'un des vias conducteurs 157.

La figure 1L illustre une structure obtenue à l'issue d'étapes de formation, sur une face d'un substrat 167 comprenant une région active 169, d'un empilement 171 de couches isolantes 173 et 175, de réalisation de vias conducteurs traversants 177 dans l'empilement 171, de formation d'un empilement 179 de couches isolantes 181 et 183 sur l'empilement 171, et de formation d'éléments de reprise de contact 185 dans l'empilement 179.

Le substrat 167 est par exemple une plaquette ou un morceau de plaquette en un matériau semiconducteur, par exemple le silicium. La région active 169 du substrat 167 comprend par exemple une pluralité de circuits intégrés de contrôle. Les circuits de contrôle, non détaillés en figure 1L dans un souci de lisibilité, sont par exemple réalisés en technologie CMOS (de l'anglais « Complementary Metal-Oxide-Semiconductor » - métal-oxide-semiconducteur complémentaire). Les circuits de commande formés dans la région active 169 sont par exemple de type ASIC (de l'anglais « Application-Specific Integrated Circuit » - circuit intégré propre à une application). À titre d'exemple, le substrat 167 présente des dimensions latérales strictement supérieures à celles du substrat de croissance 103.

Les empilements 171 et 179 sont par exemple analogues ou identiques aux empilements 151 et 159, respectivement. Par ailleurs, les vias conducteurs 177 et les éléments de reprise de contact 185 sont par exemple analogues ou identiques aux vias conducteurs 157 et aux éléments de reprise de contact 165, respectivement.

La figure 1M illustre une structure obtenue à l'issue d'étapes ultérieures de report et de fixation de l'assemblage de la figure 1K sur l'assemblage de la figure 1L. Lors de cette étape, l'ensemble comprenant le substrat de report temporaire 133, la couche 135, l'empilement 125, l'empilement 101, la couche 111, la couche 115, et les empilements 151 et 159 peut être retourné par rapport à l'orientation de la figure 1K de façon à fixer la face de l'empilement de LED 101 opposée au substrat 133 à la face supérieure du substrat 167. La face inférieure de la couche isolante 163 et les faces inférieures des éléments de reprise de contact 165, dans l'orientation de la figure 1M, peuvent être fixées respectivement à la face supérieure de la couche isolante 183 et aux faces supérieures des éléments de reprise de contact 185. Dans cet exemple, la fixation de l'empilement actif de LED 101 sur le substrat 167 est obtenu par collage direct des surfaces mises en contact, par exemple plus précisément par collage hybride métal/oxyde. À titre d'exemple, une opération de recuit, par exemple à une température égale à environ 400 °C et pendant une durée de l'ordre de 2 h, est ensuite mise en œuvre de façon à consolider le collage.

À l'issue de l'étape de report, les LED individuelles préalablement délimitées dans l'empilement actif de LED 101 sont connectées aux circuits électroniques de contrôle formés dans la région active 169 du substrat 167.

Une fois l'empilement actif de LED 101 fixé sur la face supérieure du substrat 167, le substrat de report temporaire 133 est retiré, par exemple par meulage puis gravure humide avec arrêt sélectif sur le matériau de la couche 135.

Une étape de polissage mécano-chimique est par exemple ensuite mise en œuvre du côté de la face supérieure de l'assemblage de sorte à retirer les couches 135 et 129. À titre d'exemple, le polissage mécano-chimique est effectué avec arrêt sur la couche 127.

Une couche de passivation (non représentée), par exemple en nitrure de silicium, est par exemple ensuite déposée du côté de la face supérieure de l'assemblage, et des microlentilles 187 sont réalisées à l'aplomb de chaque LED élémentaire du dispositif opto-électronique d'affichage. À titre d'exemple, les microlentilles 187 sont en un matériau isolant, par exemple le nitrure de silicium ou le nitrure de gallium.

Un avantage du procédé décrit en relation avec les figures 1A à 1M tient au fait qu'il ne comprend pas d'étape de découpe du substrat de croissance 103 en vignettes ou en puces individuelles. Cela s'avère particulièrement avantageux dans le cas où le substrat de croissance 103 est en saphir, qui est un matériau très difficile à découper.

Un autre avantage du procédé décrit en relation avec les figures 1A à 1M réside dans le fait que l'étape de retrait du substrat de croissance 103 est réalisée avant le report de l'empilement actif de LED 101 sur le substrat semiconducteur 167 dans et sur lequel sont intégrés les circuits de contrôle. Cela permet, dans le cas où ce retrait est mis en œuvre par projection d'un faisceau laser au travers du substrat 103, par exemple lors d'une étape de décollement au laser, de ne pas risquer d'endommager les circuits de contrôle.

Encore un autre avantage du procédé décrit en relation avec les figures 1A à 1M tient au fait qu'il permet d'obtenir une configuration optique optimale en termes d'extraction de lumière, en particulier du fait de la présence de LED à cavité résonante, de pentes dans le nitrure de gallium favorables à l'extraction de lumière vers le milieu extérieur, et de la possibilité de réaliser les microlentilles en nitrure de gallium.

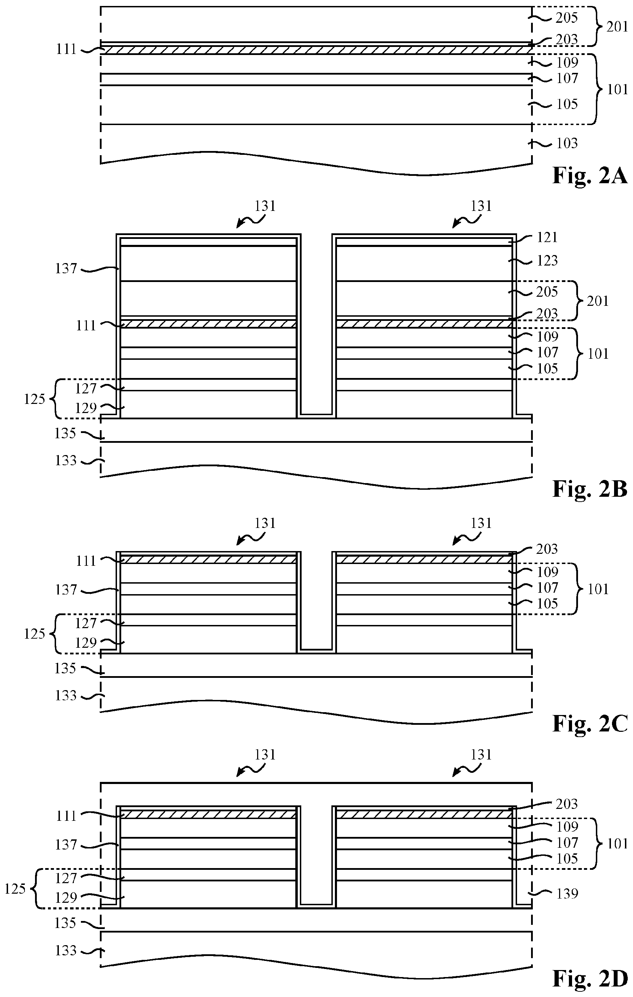

La figure 2A, la figure 2B, la figure 2C et la figure 2D sont des vues de côté et en coupe, schématiques et partielles, illustrant des structures obtenues à l'issue d'étapes d'une variante de mise en œuvre du procédé des figures 1A à 1M. La variante des figures 2A à 2D correspond par exemple de manière générale à un cas dans lequel le premier collage est un collage de type métal/métal.

La figure 2A illustre une structure obtenue à l'issue d'une étape de formation d'un empilement de collage 201 sur la face supérieure de la couche métallique 111 de la structure de la figure 1A.

Dans l'exemple représenté, l'empilement de collage 201 comprend, dans l'ordre à partir de la face supérieure de la couche métallique 111, une couche 203 en nitrure métallique, par exemple le nitrure de titane (TiN), et une couche de collage 205 en métal, par exemple le titane. Dans l'exemple illustré, la face inférieure de la couche 203 est en contact avec la face supérieure de la couche métallique 111, et la face supérieure de la couche 203 est en contact avec la face inférieure de la couche 205.

À titre d'exemple, la couche 203 présente une épaisseur de l'ordre de 40 nm. À titre d'exemple, la couche 205 présente une épaisseur de l'ordre de 600 nm.

Bien que cela n'ait pas été illustré en figure 2A afin de ne pas surcharger le dessin, une autre couche peut être interposée entre les couches 203 et 205 afin de constituer une couche d'arrêt lors d'une étape ultérieure de retrait de la couche 205.

Lors d'étapes ultérieures, par exemple analogues aux étapes précédemment décrites ci-dessus en relation avec les figures 1C à 1E :
- la structure de la figure 2A est par exemple retournée puis reportée sur le substrat de report temporaire 121, la couche de collage 123 revêtant le substrat 121 étant dans ce cas en métal, par exemple en titane ;
- le substrat de croissance 103 est retiré et l'empilement de collage 125 est formé sur l'empilement actif de LED 101 ; et
- l'assemblage est découpé de sorte à obtenir les vignettes élémentaires 131.

La figure 2B illustre une structure obtenue à l'issue d'étapes ultérieures de report et de fixation des vignettes 131 sur la face supérieure du substrat de report temporaire 133, de retrait d'une partie de l'épaisseur du substrat de report temporaire 121 et de dépôt de la couche d'encapsulation 137.

Le report des vignettes 131 sur la face supérieure du substrat de report temporaire 133 est par exemple réalisé de façon analogue ou identique à ce qui a été décrit ci-dessus en relation avec la figure 1F. À titre d'exemple, le retrait partiel du substrat de report temporaire 121 est réalisé par meulage (« grinding », en anglais). La couche d'encapsulation 137 est par exemple déposée sur toute la face supérieure de la structure, par exemple comme exposé précédemment en relation avec la figure 1G.

La figure 2C illustre une structure obtenue à l'issue d'étapes ultérieures de retrait de la totalité du substrat de report temporaire 133 et de retrait des couches de collage 123 et 207.

Le substrat de report temporaire 133 est par exemple retiré par meulage. À titre d'exemple, les couches de collage 123 et 207 sont retirées par gravure, par exemple par gravure humide, avec arrêt sur la couche 203 en nitrure métallique.

La figure 2D illustre une structure obtenue à l'issue d'étapes ultérieures de dépôt de la couche de passivation 139.

La réalisation de la couche de passivation 139 est par exemple analogue ou identique à ce qui a été précédemment décrit en relation avec la figure 1G, et ne sera pas détaillée à nouveau ci-après.

Des étapes ultérieures analogues ou identiques à celles précédemment décrites en relation avec les figures 1H à 1M sont par exemple ensuite mises en œuvre à partir de l'assemblage de la figure 2D.

La variante des figures 2A à 2D présente par exemple des avantages analogues ou identiques à ceux du procédé des figures 1A à 1M.

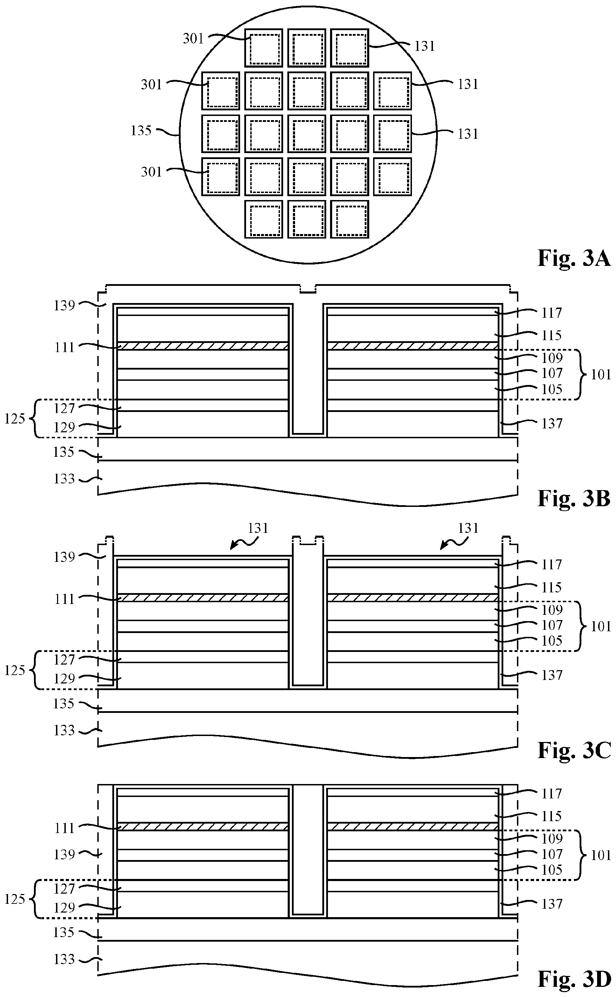

La figure 3A, la figure 3B, la figure 3C et la figure 3D sont respectivement une vue de dessus et des vues de côté et en coupe, schématiques et partielles, illustrant des structures obtenues à l'issue d'étapes d'une autre variante de mise en œuvre du procédé des figures 1A à 1M. La variante des figures 3A à 3D correspond par exemple de manière générale à un cas dans lequel le report des vignettes 131 sur le substrat de report temporaire 133 s'effectue au moyen d'un film d'eau.

La figure 3A illustre une structure obtenue à l'issue d'une étape de report et de fixation des vignettes 131 sur la couche de collage 135 revêtant le substrat de report temporaire 133. À titre d'exemple, les vignettes 131 sont obtenues selon les étapes du procédé décrites ci-dessus en relation avec les figures 1A à 1E.

Le report des vignettes 131 est par exemple réalisé par la mise en œuvre d'une technique de collage par film d'eau, par exemple comme exposé dans la demande de brevet européen n° EP 3593376 précédemment déposée par le demandeur.

Dans l'exemple illustré, les vignettes 131 présentent, en vue de dessus, une forme générale sensiblement carrée. Cet exemple n'est toutefois pas limitatif, les vignettes 131 pouvant, à titre de variante, présenter une forme générale quelconque, par exemple rectangulaire, ovale, circulaire, etc.

À l'issue de l'étape de report et de fixation, les vignettes 131 sont par exemple désalignées latéralement et/ou angulairement par rapport à des positions souhaitées des vignettes 131. Afin de pallier ce problème, les vignettes 131 sont par exemple gravées de sorte à obtenir des vignettes 301 alignées par rapport aux positions souhaitées. Pour pouvoir mettre en œuvre cette correction de désalignement, il est par exemple prévu que les vignettes 131 présentent des dimensions latérales strictement supérieures à celles des vignettes 301 souhaitées après report sur le substrat de report temporaire 133.

La figure 3B illustre une structure obtenue à l'issue d'étapes ultérieures de dépôt de la couche d'encapsulation 137 et de dépôt de la couche isolante de passivation 139, par exemple comme exposé précédemment en relation avec la figure 1G.

La figure 3C illustre une structure obtenue à l'issue d'une étape ultérieure de structuration de la couche isolante de passivation 139, par exemple par photolithographie puis gravure à l'aplomb de chaque vignette 131.

Dans l'exemple représenté, la couche 139 est retirée à l'aplomb de chaque vignette 131 de sorte à exposer la face supérieure (dans l'orientation de la figure 3C) de la couche 137 située sur chaque vignette 131.

La figure 3D illustre une structure obtenue à l'issue d'une étape ultérieure de planarisation de la structure de la figure 3C du côté de la face supérieure (dans l'orientation de la figure 3D) du substrat de report temporaire 133.

Dans l'exemple représenté, à l'issue de cette étape, la face supérieure de la couche isolante de passivation 139 affleure les faces supérieures des vignettes 131, plus précisément les faces supérieures des parties de la couche 137 revêtant chaque vignette. À titre d'exemple, l'étape de planarisation est réalisée par polissage mécano-chimique, par exemple avec arrêt sur la couche 137.

La variante des figures 3A à 3D présente par exemple des avantages analogues ou identiques à ceux du procédé des figures 1A à 1M.

Un autre avantage de la variante décrite ci-dessus en relation avec les figures 3A à 3D tient au fait qu'elle permet d'améliorer grandement la planéité de l'assemblage, ce qui constitue un élément clé pour la réalisation ultérieure du collage hybride sur le substrat 167.

Des étapes ultérieures analogues ou identiques à celles précédemment décrites en relation avec les figures 1H à 1M sont par exemple ensuite mises en œuvre à partir de l'assemblage de la figure 1G.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la variante des figures 2A à 2D et la variante des figures 3A à 3D peuvent être combinées.

En outre, les types de conductivité des couches semiconductrices 105 (de type N, dans les exemples décrits) et 109 (de type P, dans les exemples décrits) peuvent être inversés.

Par ailleurs, bien que des exemples de réalisation de dispositifs d'affichage comprenant des LED à base de nitrure de gallium aient été détaillés, les modes de réalisation décrits peuvent être adaptés par la personne du métier à la fabrication d'un dispositif comportant une pluralité de photodiodes à base de nitrure de gallium adressables de façon individuelle pour acquérir des images.

Plus généralement, les modes de réalisation décrits peuvent être adaptés à la fabrication de tout dispositif d'affichage ou capteur photosensible à base de diodes semiconductrices, y compris à base de matériaux semiconducteurs autres que le nitrure de gallium, par exemple des diodes à base d'autres matériaux semiconducteurs III-V.

Les modes de réalisation décrits peuvent en outre être adaptés à la fabrication de tout dispositif électronique comportant une pluralité de composants semiconducteurs à base de nitrure de gallium ou à base d'autres matériaux semiconducteurs, par exemple des matériaux III-V, et un circuit intégré adapté à commander individuellement ces composants. À titre d'exemple, les composants semiconducteurs peuvent être des composants de puissance, par exemple des transistors, des diodes, etc.

Enfin, la mise en œuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés dans la présente description.

## Revendications

1. Procédé de fabrication de dispositifs opto-électroniques, comprenant les étapes successives suivantes :
a) former, par croissance épitaxiale sur un substrat de croissance (103), un empilement actif de diode (101) ;
b) reporter, sur un premier substrat de report (121), l'empilement actif de diode ;
c) retirer le substrat de croissance ;
d) former, par découpe du premier substrat de report et de l'empilement actif de diode, une pluralité de vignettes élémentaires (131) ; et
e) reporter, sur un deuxième substrat de report (133), les vignettes élémentaires comprenant chacune une partie de l'empilement actif de diode.

2. Procédé selon la revendication 1, dans lequel, à l'étape b), le substrat de croissance (103) ou le substrat de report (121), est chauffé, de préférence à une température supérieure ou égale à 40 °C, plus préférentiellement supérieure ou égale à 70 °C.

3. Procédé selon la revendication 1, dans lequel, à l'étape b), le substrat de croissance (103) et le substrat de report (121) sont chauffés, de préférence à une température supérieure ou égale à 40 °C.

4. Procédé selon la revendication 1, 2 ou 3, dans lequel, à l'étape b), l'empilement actif de diode (101) est fixé sur le premier substrat de report (121) par collage direct d'une première couche de collage (119), préalablement déposée sur la face de l'empilement actif de diode opposée au substrat de croissance, avec une deuxième couche de collage (123), préalablement déposée sur le premier substrat de report.

5. Procédé selon la revendication 4, dans lequel, à l'étape b), les surfaces des première (119) et deuxième (123) couches de collage destinées à être mises en contact sont activées préalablement à la fixation.

6. Procédé selon la revendication 4 ou 5, dans lequel les première (119) et deuxième (123) couches de collage sont en silicium amorphe.

7. Procédé selon la revendication 4 ou 5, dans lequel les première (119) et deuxième (123) couches de collage sont des couches métalliques, de préférence en titane.

8. Procédé selon l'une quelconque des revendications 1 à 7, dans lequel, à l'étape e), les vignettes élémentaires (131) sont fixées sur le deuxième substrat de report (133) par collage direct d'une troisième couche de collage (129), préalablement déposée sur la face de l'empilement actif de diode (101) opposée au premier substrat de report (121), avec une quatrième couche de collage (135), préalablement déposée sur le deuxième substrat de report.

9. Procédé selon la revendication 8, dans lequel les troisième (129) et quatrième (135) couches de collage sont en oxyde de silicium.

10. Procédé selon l'une quelconque des revendications 1 à 9, comprenant en outre, après l'étape e), l'étape suivante :
f) reporter l'ensemble comprenant le deuxième substrat de report (133) et les parties de l'empilement actif de diode (101) sur un substrat actif (167) comprenant des circuits intégrés de contrôle.

11. Procédé selon la revendication 10, dans lequel, à l'étape f), les parties de l'empilement actif de diode (101) et le deuxième substrat de report (133) sont fixés au substrat actif (167) par collage d'une première couche isolante (163), préalablement déposée sur la face de l'empilement actif de diode opposée au deuxième substrat de report, et de premiers éléments de reprise de contact (165), situés dans la première couche isolante, avec respectivement une deuxième couche isolante (183), préalablement déposée sur le substrat actif, et des deuxièmes éléments de reprise de contact (185), situés dans la deuxième couche isolante.

12. Procédé selon l'une quelconque des revendications 1 à 11, comprenant en outre, après l'étape e), une étape g) de gravure des vignettes élémentaires (131) de sorte à compenser un désalignement des vignettes élémentaires par rapport au deuxième substrat de report (133).

13. Procédé selon la revendication 12, comprenant en outre, après l'étape g), une étape h) de dépôt d'une couche isolante (139) comblant des espaces s'étendant latéralement entre les vignettes élémentaires (131) puis de retrait de parties de la couche isolante situées à l'aplomb des vignettes élémentaires (131).

14. Procédé selon l'une quelconque des revendications 1 à 13, dans lequel le substrat de croissance (103) est en saphir.

15. Procédé selon l'une quelconque des revendications 1 à 14, dans lequel l'empilement actif de diode (101) comprend du nitrure de gallium.

16. Procédé selon l'une quelconque des revendications 1 à 15, dans lequel l'empilement actif de diode (101) est un empilement de diode électroluminescente comportant, dans l'ordre à partir du substrat de croissance (103), des première (105) et deuxième (109) couches semiconductrices de types de conductivités opposés.

## Patentansprüche

1. Ein Verfahren zur Herstellung optoelektronischer Einrichtungen, das die folgenden aufeinanderfolgenden Schritte aufweist:
a) Ausbilden, durch epitaktisches Wachstum auf einem Wachstumssubstrat (103), eines aktiven Diodenstapels (101);
b) Übertragen des aktiven Diodenstapels auf ein erstes Übertragungssubstrat (121);
c) Entfernen des Wachstumssubstrats;
d) Ausbilden, durch Schneiden des ersten Übertragungssubstrats und des aktiven Diodenstapels, einer Vielzahl von Dies (131); und
e) Übertragen der Dies, die jeweils einen Abschnitt des aktiven Diodenstapels aufweisen, auf ein zweites Übertragungssubstrat (133).

2. Das Verfahren nach Anspruch 1, wobei in Schritt b) das Wachstumssubstrat (103) oder das Übertragungssubstrat (121) erwärmt wird, vorzugsweise auf eine Temperatur größer als oder gleich 40°C, weiter bevorzugt größer als oder gleich 70°C.

3. Das Verfahren nach Anspruch 1, wobei in Schritt b) das Wachstumssubstrat (103) und das Übertragungssubstrat (121) erwärmt werden, vorzugsweise auf eine Temperatur größer als oder gleich 40°C.

4. Das Verfahren nach Anspruch 1, 2 oder 3, wobei in Schritt b) der aktive Diodenstapel (101) an das erste Übertragungssubstrat (121) durch direktes Bonden einer ersten Bondschicht (119), die zuvor auf der Oberfläche des aktiven Diodenstapels gegenüber dem Wachstumssubstrat abgeschieden wurde, mit einer zweiten Bondschicht (123), die zuvor auf dem ersten Übertragungssubstrat abgeschieden wurde, gebondet wird.

5. Das Verfahren nach Anspruch 4, wobei in Schritt b) die Oberflächen der ersten (119) und der zweiten (123) Bondschicht, die dazu bestimmt sind, miteinander in Kontakt gebracht zu werden, vor dem Bonden aktiviert werden.

6. Das Verfahren nach Anspruch 4 oder 5, wobei die erste (119) und die zweite (123) Bondschicht aus amorphem Silizium hergestellt sind.

7. Das Verfahren nach Anspruch 4 oder 5, wobei die erste (119) und die zweite (123) Bondschicht Metallschichten, vorzugsweise aus Titan hergestellt, sind.

8. Das Verfahren nach einem der Ansprüche 1 bis 7, wobei in Schritt e) die Dies (131) an das zweite Übertragungssubstrat (133) gebondet werden, durch direktes Bonden einer dritten Bondschicht (129), die zuvor auf der Oberfläche des aktiven Diodenstapels (101) gegenüber dem ersten Übertragungssubstrat (121) abgeschieden wurde, mit einer vierten Bondschicht (135), die zuvor auf dem zweiten Übertragungssubstrat abgeschieden wurde.

9. Das Verfahren nach Anspruch 8, wobei die dritte (129) und die vierte (135) Bondschicht aus Siliziumoxid hergestellt sind.

10. Das Verfahren nach einem der Ansprüche 1 bis 9, das ferner nach Schritt e) den folgenden Schritt aufweist:
f) Übertragen der Anordnung, die das zweite Übertragungssubstrat (133) und die Abschnitte des aktiven Diodenstapels (101) aufweist, auf ein aktives Substrat (167), das integrierte Steuerschaltungen aufweist.

11. Das Verfahren nach Anspruch 10, wobei in Schritt f) die Abschnitte des aktiven Diodenstapels (101) und das zweite Übertragungssubstrat (133) an das aktive Substrat (167) gebondet werden, durch Bonden einer ersten Isolierschicht (163), die zuvor auf der dem zweiten Übertragungssubstrat gegenüberliegenden Oberfläche des aktiven Diodenstapels abgeschieden wurde, und erster Kontaktelemente (165), die sich in der ersten Isolierschicht befinden, jeweils mit einer zweiten Isolierschicht (183), die zuvor auf dem aktiven Substrat abgeschieden wurde, und zweiten Kontaktelementen (185), die sich in der zweiten Isolierschicht befinden.

12. Das Verfahren nach einem der Ansprüche 1 bis 11, das ferner nach Schritt e) einen Schritt g) des Ätzens der Dies (131) aufweist, um eine Fehlausrichtung der Dies in Bezug auf das zweite Übertragungssubstrat (133) auszugleichen.

13. Das Verfahren nach Anspruch 12, das ferner nach Schritt g) einen Schritt h) des Abscheidens einer Isolierschicht (139), die sich seitlich zwischen den Dies (131) erstreckende Zwischenräume füllt, und anschließend des Entfernens von Abschnitten der Isolierschicht, die sich vertikal in einer Linie mit den Dies (131) befinden, aufweist.

14. Das Verfahren nach einem der Ansprüche 1 bis 13, wobei das Wachstumssubstrat (103) aus Saphir hergestellt ist.

15. Das Verfahren nach einem der Ansprüche 1 bis 14, wobei der aktive Diodenstapel (101) Galliumnitrid aufweist.

16. Das Verfahren nach einem der Ansprüche 1 bis 15, wobei der aktive Diodenstapel (101) ein Leuchtdiodenstapel ist, der, in der Reihenfolge ausgehend von dem Wachstumssubstrat (103), eine erste (105) und eine zweite (109) Halbleiterschicht entgegengesetzter Leitfähigkeitstypen aufweist.

## Claims

1. Method of manufacturing optoelectronic devices, comprising the following successive steps:
a) forming, by epitaxial growth on a growth substrate (103), an active diode stack (101);
b) transferring, onto a first transfer substrate (121), the active diode stack;
c) removing the growth substrate;
d) forming, by cutting of the first transfer substrate and of the active diode stack, a plurality of dies (131); and
e) transferring, onto a second transfer substrate (133), the dies each comprising a portion of the active diode stack.

2. Method according to claim 1, wherein, at step b), the growth substrate (103) or the transfer substrate (121) is heated, preferably up to a temperature higher than or equal to 40°C, more preferably higher than or equal to 70°C.

3. Method according to claim 1, wherein, at step b), the growth substrate (103) and the transfer substrate (121) are heated, preferably up to a temperature higher than or equal to 40°C.

4. Method according to claim 1, 2 or 3, wherein, at step b), the active diode stack (101) is bonded to the first transfer substrate (121) by direct bonding of a first bonding layer (119), previously deposited on the surface of the active diode stack opposite to the growth substrate, with a second bonding layer (123), previously deposited on the first transfer substrate.

5. Method according to claim 4, wherein, at step b), the surfaces of the first (119) and second (123) bonding layers intended to be brought into contact are activated prior to bonding.

6. Method according to claim 4 or 5, wherein the first (119) and second (123) bonding layers are made of amorphous silicon.

7. Method according to claim 4 or 5, wherein the first (119) and second (123) bonding layers are metal layers, preferably made of titanium.

8. Method according to any one of claims 1 to 7, wherein, at step e), the dies (131) are bonded to the second transfer substrate (133) by direct bonding of a third bonding layer (129), previously deposited on the surface of the active diode stack (101) opposite to the first transfer substrate (121), with a fourth bonding layer (135), previously deposited on the second transfer substrate.

9. Method according to claim 8, wherein the third (129) and fourth (135) bonding layers are made of silicon oxide.

10. Method according to any one of claims 1 to 9, further comprising, after step e), the following step:
f) transferring the assembly comprising the second transfer substrate (133) and the portions of the active diode stack (101) onto an active substrate (167) comprising integrated control circuits.

11. Method according to claim 10, wherein, at step f), the portions of the active diode stack (101) and the second transfer substrate (133) are bonded to the active substrate (167) by bonding of a first insulating layer (163), previously deposited on the surface of the active diode stack opposite to the second transfer substrate, and of first contacting elements (165), located in the first insulating layer, with respectively a second insulating layer (183), previously deposited on the active substrate, and of second contacting elements (185), located in the second insulating layer.

12. Method according to any one of claims 1 to 11, further comprising, after step e), a step g) of etching of the dies (131) so as to compensate for a misalignment of the dies with respect to the second transfer substrate (133).

13. Method according to claim 12, further comprising, after step g), a step h) of deposition of an insulating layer (139) filling gaps laterally extending between the dies (131) and then of removal of portions of the insulating layer located vertically in line with the dies (131).

14. Method according to any one of claims 1 to 13, wherein the growth substrate (103) is made of sapphire.

15. Method according to any one of claims 1 to 14, wherein the active diode stack (101) comprises gallium nitride.

16. Method according to any one of claims 1 to 15, wherein the active diode stack (101) is a light-emitting diode stack comprising, in the order from the growth substrate (103), first (105) and second (109) semiconductor layers of opposite conductivity types.
